Europäisches Patentamt

European Patent Office

Office européen des brevets

(11) Veröffentlichungsnummer: **0 1 19 439**
**B1**

(12) **EUROPÄISCHE PATENTSCHRIFT**

(45) Veröffentlichungstag der Patentschrift:
**11.05.88**

(51) Int. Cl.⁴: **H 03 D 7/02,** H 03 J 5/02

(21) Anmeldenummer: **84101362.6**

(22) Anmeldetag: **10.02.84**

(54) Diodenmischer mit Vorspannungssteuerung sowie dessen Anwendung.

(30) Priorität: **16.03.83 DE 3309399**

(43) Veröffentlichungstag der Anmeldung:
**26.09.84 Patentblatt 84/39**

(45) Bekanntmachung des Hinweises auf die Patenterteilung:
**11.05.88 Patentblatt 88/19**

(84) Benannte Vertragsstaaten:
**AT CH DE FR GB LI NL**

(56) Entgegenhaltungen:
**EP - A - 0 046 835**
**CH - A - 412 024**
**DE - A - 2 047 909**
**DE - A - 2 814 577**
**DE - A - 2 834 231**
**US - A - 2 425 454**

(73) Patentinhaber: **ANT Nachrichtentechnik GmbH,**
**Gerberstrasse 33, D-7150 Backnang (DE)**

(72) Erfinder: **Schiller, Wolfgang, Dipl.-Ing.,**
**Bismarkstrasse 22, D-7100 Heilbronn (DE)**

ACTORUM AG

**Beschreibung**

Die Erfindung betrifft einen Diodenmischer gemäss dem Oberbegriff des Patentanspruchs 1.

Aus Mikrowellen Magazin, Vol. 8, No. 6, 1982, Seite 720, ist es bekannt, den Mischdioden in Mischstufen Steuergleichspannungen zuzuführen. Mit einer solchen Steuergleichspannung können parasitäre Einflüsse beim Mischvorgang ausgeglichen werden.

Aus der EP-A-44 156 ist es grundsätzlich bekannt, Einseitenbandmischern ein Oszillatorsignal zuzuführen, welches von einem Frequenzsynthesizer abgeleitet ist.

Aus der DE-A-2 834 231 ist es bekannt, bei einem Überladungsempfänger zur Einstellung der Kapazitätsdioden in der Vorstufe und im Oszillator Speicher vorzusehen, die die entsprechenden Kapazitätswerte für die gewünschten Frequenzen enthalten. Die die Kapazität einstellende Steuergleichspannung für die Kapazitätsdioden wird über zwischengeschaltete Digital-/Analogwandler erhalten.

Es ergibt sich beim Wechsel auf einen anderen Übertragungskanal, d.h. bei einer Änderung des Oszillatorsignals, das Problem die Vorspannungen an den Mischerdioden auch entsprechend ändern zu müssen.

Der Erfindung liegt daher die Aufgabe zugrunde, einen Diodenmischer gemäss dem Oberbegriff des Patentanspruchs 1 so auszubilden, dass beim Wechsel der Oszillatorfrequenz immer eine geeignete Steuergleichspannung für die Mischerdioden bereitgestellt wird.

Erfindungsgemäss wird diese Aufgabe durch die Merkmale des Patentanspruchs 1 gelöst. In den abhängigen Ansprüchen sind vorteilhafte Ausgestaltungen der Erfindung angegeben.

Die Erfindung ermöglicht durch die zu jeder Oszillatorfrequenz individuell eingestellte Vorspannung an den Mischerdioden eine Verbesserung der Symmetrieeigenschaften. Hierdurch kann die Oszillatorunterdrückung insbesondere bei Verwendung des Mischers als Einseitenbandmischer sehr grosse Werte annehmen, beispielsweise bis zu 40 dB. Es ergibt sich durch die erfindungsgemässe Lösung eine Steigerung der verwendbaren Bandbreite um mehr als das Doppelte je nach dem benötigten Temperaturbereich des Mischers. Der erfindungsgemässe Mischer kann leicht fernsteuerbar gemacht werden, da bei Frequenzwechsel ein Nachjustieren der Vorspannung entfällt. Der Abgleich der zu jeder Oszillatorfrequenz gehörigen Vorspannung kann einfach durchgeführt werden. Der Mischer nach der Erfindung lässt sich insbesondere als Gegentakt-Einseitenband-Aufwärtsmischer verwenden.

Anhand der Zeichnungen wird der erfindungsgemässe Mischer nun näher beschrieben.

Es zeigen:

Fig. 1 ein Blockschaltbild eines Einseitenbandmischers,

Fig. 2 das Ausgangsspektrum dieses Einseitenbandmischers,

Fig. 3 ein Blockschaltbild des Frequenzsynthesizers,

Fig. 4 die Speichereinrichtung mit Mitteln zur Ansteuerung der Mischstufen,

Fig. 5 eine Prinzipschaltung einer Mischstufe.

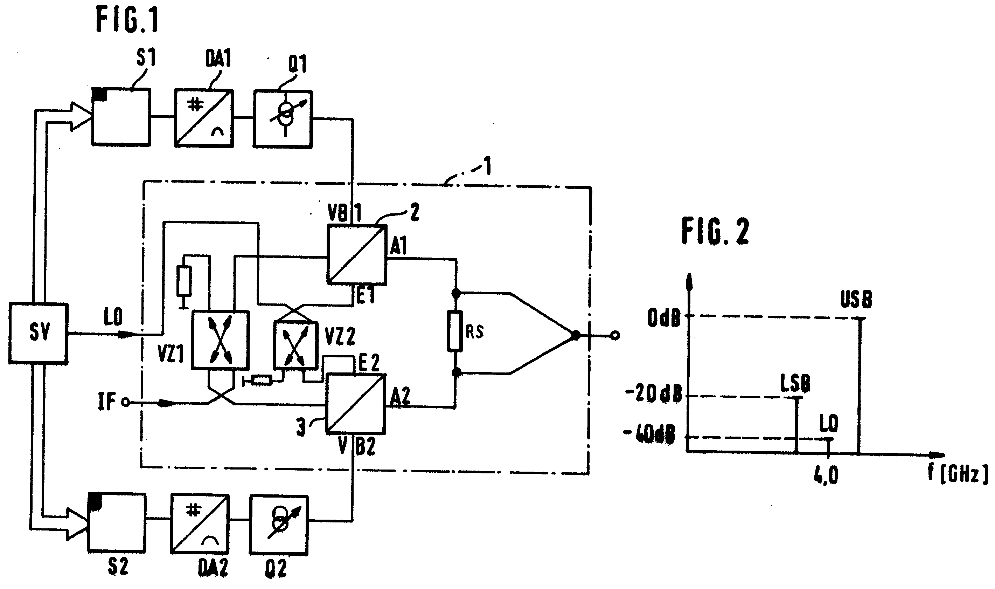

In Fig. 1 ist ein breitrandiger Einseitenbandaufwärtsmischer 1 mit elektronisch gesteuerter Trägerunterdrückung für die Übertragung von 16 QAM-Signalen im Gigahertzbereich dargestellt. Der Aufwärtsmischer 1 enthält 2 Mischstufen 2 und 3, denen ein Zwischenfrequenzsignal IF über eine 90°/3dB-Verzweigung VZ1 zugeführt wird. Die Oszillatorfrequenz LO zur Umsetzung der Zwischenfrequenz IF in die Radiofrequenz RF wird den Eingängen E1 und E2 der Mischstufen 2 und 3 über eine weitere 90°/3dB-Verzweigung VZ2 gleichfrequent zugeführt. Über Steuereingänge VB1 und VB2 werden den Mischdioden D1, D2 (vgl. Fig. 5) Steuergleichspannungen zugeführt. Die vorwählbaren Oszillatorfrequenzen LO werden von einem Synthesizer SY erzeugt. Die Digitalausgänge des Synthesizers SY sind mit Speichereinrichtungen S1 und S2 verbunden. Digital/Analogwandler DA1 und DA2 wandeln die in den Speichereinrichtungen S1 und S2 für jede zugehörige vorwählbare Oszillatorfrequenz LO vorliegenden Digitalworte in Analogwerte um. Diese Analogwerte steuern jeweils eine bipolare Spannungsquelle Q1 und Q2 deren Ausgänge an die Steuereingänge VB1 und VB2 geführt sind. Durch die Gleichspannungssteuerung der Mischstufen 2 und 3, bzw. deren Mischdioden D1 und D2, kann die Symmetrie der Mischstufen verbessert werden, was zur Verbesserung der Trägerunterdrückung führt. Bei Änderung der Oszillatorfrequenz wird die Vorspannung für die Mischerdioden D1 und D2 automatisch mitgeändert. Die an den Ausgängen A1 und A2 der Mischstufen anstehenden hochgemischten Radiofrequenzsignale RF werden über einen geeigneten Summierer zusammengeführt. Die Spiegelfrequenzen werden im Widerstand RS absorbiert.

Die bisher übliche Ausfilterung der Radiofrequenz RF kann daher entfallen.

Fig. 2 zeigt das Ausgangsspektrum des Einseitenbandmischers. Mit USB ist das obere und mit LSB das untere Seitenband bezeichnet. LO bezeichnet die Oszillatorfrequenz, d.h. den Träger. Wie aus Fig. 2 ersichtlich ist, beträgt die Trägerunterdrückung bezüglich USB 40dB.

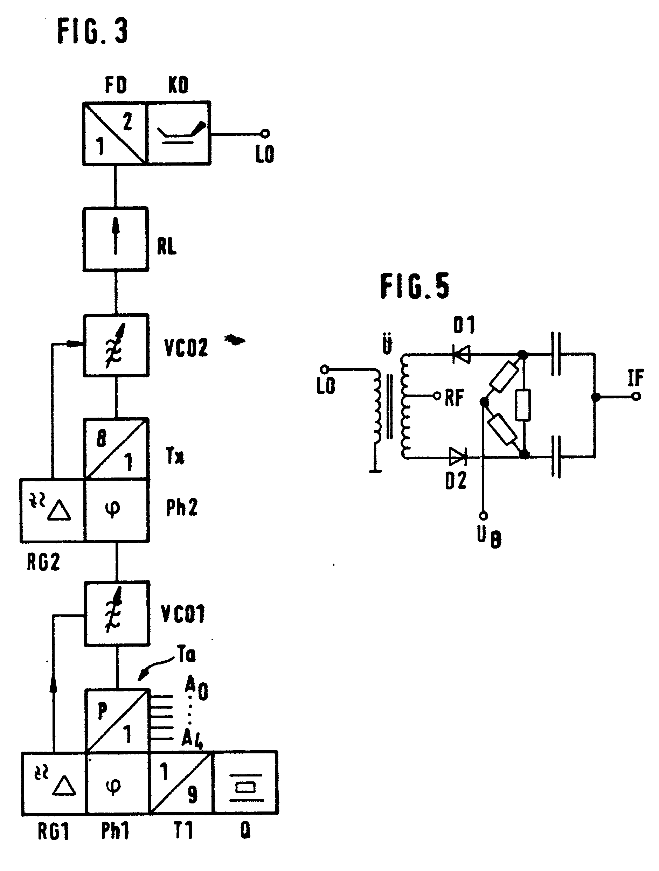

In Fig. 3 ist der prinzipielle Aufbau eines beispielhaften Synthesizers SY dargestellt. Das Ausgangssignal des ersten VCO's – VCO1 – wird über einen adressierbaren Frequenzteiler $T_a$ heruntergeteilt, ebenfalls das Ausgangssignal des Quarzoszillators Q, und diese Signale werden über eine Phasendiskriminator Ph1 und die PLL-Rückführschleife RG1 dem VCO1 wieder zugeführt. Die Ausgangsfrequenz beträgt 250 kHz. An den ersten VCO schliesst sich ein zweiter – VCO2 – an, der über einen festen Teiler Tx in einem Phasendiskriminator Ph2 mit der Ausgangsfrequenz des ersten VCO's verglichen und über PLL-Rückführschleife RG2 nachgeregelt wird. Der zweite VCO liefert eine Ausgangsfrequenz von 2 GHz. Über eine Richtungsleitung RL, eine Frequenzverdopplerstufe FD und einen Koppler KO wird die Oszillatorfrequenz LO entnommen.

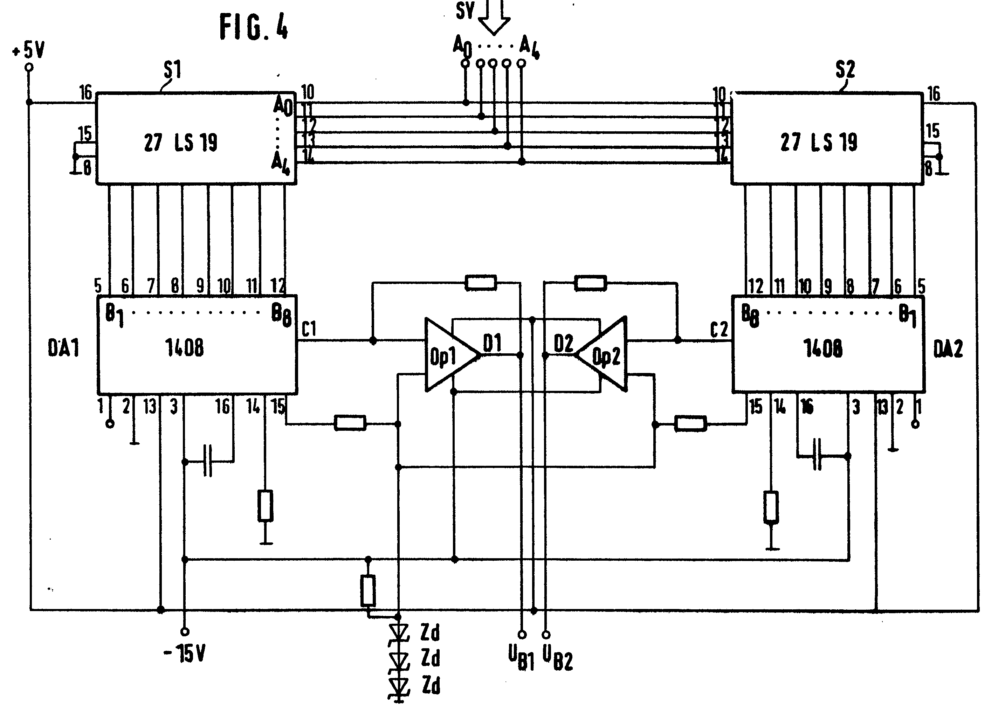

Die Adressiereingänge $A_0$ bis $A_4$ des Frequenzteilers Ta sind mit einem Speicher (nicht dargestellt) verbunden, in welchem die Informationen für jede mögliche vorwählbare Oszillatorfrequenz LO in digitaler Form abgelegt sind. Diese Adressiereingänge $A_0$ bis $A_4$ sind jeweils, wie dies Fig. 4 zeigt, mit den Eingängen eines PROM-Speichers S1 und S2 verbunden. Von den Adressiereingängen des Synthesizers SY gelangt für jede mögliche Oszillatorfrequenz LO ein 5 Bit-Digitalwort statisch parallel jeweils an ein PROM S1 und S2. Dieses Digitalwort ändert sich bei Kanalwechsel. Zu jedem möglichen Eingangssignal, im Ausführungsbeispiel sind dies 32 mögliche Signale, da 32 Kanäle vorgesehen sind, erzeugt jedes PROM ein 8 Bit-Ausgangssignal, ebenfalls statisch und parallel. Das Ausgangssignal $O_0$ bis $O_7$ jedes PROMS gelangt an die Eingänge $B_1$ bis $B_8$ der D/A-Wandler DA1 und DA2 und wird dort in eine Gleichspannung umgewandelt. Diese Gleichspannungen sind an den Ausgängen $C_1$ und $C_2$ der D/A-Wandler verfügbar. Als PROMS können integrierte Schaltkreise mit der Bezeichnung 27 LS 19 und für die D/A-Wandler solche mit der Bezeichnung 1408 verwendet werden. Eine Gegentaktmischstufe benötigt ein PROM. Ein Einseitenbandmischer benötigt zwei PROMS, da er zwei Gegentaktmischer enthält.

Die Ausgänge $C_1$ und $C_2$ der D/A-Wandler sind jeweils mit einer bipolaren Spannungsquelle Q1 und Q2 verbunden. Diese bipolaren Spannungsquellen sind durch die Operationsverstärker Op1 und Op2 realisiert. Die Ausgänge $C_1$ und $C_2$ sind jeweils an die invertierenden Eingänge von Op1 und Op2 geführt. Die nichtinvertierenden Eingänge von Op1 und Op2 sind an eine Referenzspannung gelegt, die an der Serienschaltung aus drei Zenerdioden Zd abfällt. Der Ausgang D1 des Operationsverstärkers Op1 ist mit der Mischstufe 2 über den Eingang VB1 und der Ausgang D2 des Operationsverstärkers Op2 ist mit der Mischstufe 3 über den Eingang VB2 verbunden.

Den prinzipiellen Aufbau der Mischstufen 2 und 3, die gleich aufgebaut sind, zeigt Fig. 5. Die Oszillatorfrequenz LO wird in einem Übertrager Ü primärseitig eingespeist. Die Wicklungsenden der Sekundärwicklung des Übertragers Ü sind mit den Mischerdioden D1 und D2 verbunden und zwar das eine Ende mit einer Kathode und das andere Ende mit einer Anode einer Mischerdiode. Die dem Übertrager Ü abgewandten Enden der Mischerdioden sind über Gleichspannungsabtrennkondensatoren miteinander verbunden. An diesem Verbindungspunkt wird die umzusetzende Frequenz IF eingespeist. Die Steuergleichspannung $U_B$ wird jeder Mischstufe über eine Widerstanddreieckschaltung zugeführt. Zwei Ecken der Dreieckschaltung sind jeweils an den Verbindungspunkten zwischen den Mischerdioden D1 und D2 und den Gleichspannungsabtrennkondensatoren angeschlossen. An der dritten Ecke der Dreiecksschaltung wird die Steuergleichspannung $U_B$ zugeführt. Die Radiofrequenz RF kann am Mittelabgriff der Sekundärwicklung des Übertragers Ü abgenommen werden. Als Mischerdioden eignen sich vorzugsweise High Barrier Silizium Schottky-Dioden. Pro Gegentaktmischer wird jeweils eine Diode soweit in Flussrichtung vorgespannt, dass ein Strom von 0 bis max. 3mA fliesst.

Beim Abgleich muss zu jedem verwendeten Kanal (Oszillatorfrequenz LO) der Zusammenhang zwischen dem 5 Bit-Wort der Frequenzinformation vom Oszillator und dem 8 Bit-Wort für die Ansteuerung des D/A-Wandlers ermittelt werden. Dazu muss für jeden Kanal die Trägerunterdrückung gemessen werden. Für den Abgleich werden zunächst die PROMS aus der Steuerschaltung für jede Mischstufe entfernt. Durch Anlegen aller 256 möglichen Eingangskombinationen an die beiden D/A-Wandler kann die Ausgangsspannung der Operationsverstärker von +3V bis −3V in 256 Inkrementen eingestellt werden. Mit einem Spektrumanalysator wird beobachtet, bei welchen beiden Eingangskombinationen der D/A-Wandler der Trägerunterdrückung optimal wird. Diese Werte werden zusammen mit der dazugehörigen Frequenzinformation gespeichert. Nachdem so alle Kanäle durchgemessen sind, kann mit den gespeicherten Informationen das PROM programmiert werden. Beispielsweise kann man alle 256 Eingangskombinationen durch Ansteuerung des A/D-Wandlers mit einem 10 Gang-Potentiometer einstellen. Nach der Programmierung des PROMS wird dieses in die Steuerschaltung eingesetzt. Damit ist für jede vorwählbare Frequenz die erforderliche Steuergleichspannung eingestellt.

**Patentansprüche**

1. Diodenmischer, bestehend aus mindestens einer Mischstufe (2, 3), der eine umzusetzende Frequenz (IF) und eine vorwählbare Oszillatorfrequenz (LO) zugeführt ist, wobei den Mischdioden (D1, D2) jeder Mischstufe (2, 3) zum Ausgleich parasitärer Einflüsse Steuergleichspannungen zugeführt sind, dadurch gekennzeichnet, dass den Eingängen für die Steuergleichspannungen der Mischstufen Speichereinrichtungen (S1, S2) derart zugeordnet sind, dass für jede vorwählbare Oszillatorfrequenz (LO) aus dem Speicherinhalt der Speichereinrichtungen (S1, S2) eine entsprechende Steuergleichspannung erzeugt wird.

2. Diodenmischer nach Anspruch 1 unter Verwendung eines Frequenzsynthesizers (SY) zur Erzeugung der Oszillatorfrequenz (LO), dadurch gekennzeichnet, dass jene Ausgänge des Frequenzsynthesizers (SY) an denen die Informationen über die Frequenz (LO) in digitaler Form vorliegt, mit den Eingängen der Speichereinrichtungen (S1, S2) verbunden sind, dass die Ausgänge der Speichereinrichtungen (S1, S2) mit den Eingängen von Digital-Analogwandlern (DA1, DA2) verbunden sind, und dass die Ausgänge der Digital-Analogwandler (DA1, DA2) jeweils mit einer gesteuerten bipolaren Spannungsquelle (Q1, Q2) so verbunden sind, dass das zu jeder vorgewählten Oszillatorfrequenz gehörige in Analogwerte um-

gewandelte Digitalwort die entsprechende Steuergleichspannung für die Mischdioden (D1, D2) erzeugt.

3. Diodenmischer nach Anspruch 1 oder 2, dadurch gekennzeichnet, dass die Speichereinrichtungen (S1, S2) aus PROMS oder E-PROMS bestehen.

4. Diodenmischer nach Anspruch 1 oder 2, dadurch gekennzeichnet, dass die bipolar gesteuerten Spannungsquellen (Q1, Q2) aus Operationsverstärkern bestehen.

## Claims

1. A diode mixer arrangement comprising at least one mixer stage (2, 3) to which is fed a frequency (IF) to be converted and a preselectable oscillator frequency (LO), with the mixer diodes (D1, D2) of each mixer stage (2, 3) receiving direct control voltages so as to compensate parasitic influences, characterized in that the inputs for the direct control voltages of the mixer stages have associated memory devices (S1, S2) in such a manner that for each preselectable oscillator frequency (LO) a corresponding direct control voltage is generated from the memory contents of the memory devices (S1, S2).

2. A diode mixer arrangement according to claim 1 employing a frequency synthesizer (SY) for generating the oscillator frequency (LO), characterized in that those outputs of the frequency synthesizer (SY) at which the information regarding the frequency (LO) is present in digital form are connected with the inputs of the memory devices (S1, S2); the outputs of the memory devices (S1, S2) are connected with the inputs of digital/analog converters (DA1, DA2); and the outputs of the digital/analog converters (DA1, DA2) are each connected with a controllable bipolar voltage source (Q1, Q2) in such a manner that the digital word, converted into analog values and associated with each preselected oscillator frequency, generates the corresponding direct control voltage for the mixer diodes (D1, D2).

3. A diode mixer arrangement according to claim 1 or 2, characterized in that the memory devices (S1, S2) are composed of PROMS or E-PROMS.

4. A diode mixer arrangement according to claim 1 or 2, characterised in that the controllable bipolar voltage sources (Q1, Q2) are composed of operational amplifiers.

## Revendications

1. Mélangeur à diodes, constitué par au moins un étage mélangeur (2, 3) auquel sont amenées une fréquence à convertir (IF) et une fréquence d'oscillateur présélectionnable (LO), les diodes mélangeuses (D1, D2) de chaque étage mélangeur (2, 3) recevant des tensions continues de commande pour éliminer les influences parasites, caractérisé par le fait que des dispositifs de mémoire (S1, S2) sont associés aux entrées pour les tensions continues de commande des étages mélangeurs, de manière telle que, pour chaque fréquence d'oscillateur présélectionnable (LO), une tension de commande continue correspondante soit produite à partir du contenu mémorisé dans les dispositifs de mémoire (S1, S2).

2. Mélangeur à diodes selon revendication 1, avec utilisation d'un synthétiseur de fréquence (SY) pour produire la fréquence d'oscillateur (LO), caractérisé par le fait que celles des sorties du synthétiseur de fréquence (SY) auxquelles les informations concernant la fréquence (LO) sont présentes, sous forme numérique, sont reliées aux entrées des dispositifs de mémoire (S1, S2), par le fait que les sorties des dispositifs de mémoire (S1, S2) sont reliées aux entrées de convertisseur numérique-analogique (DA1, DA2) et par le fait que les sorties des convertisseurs numérique-analogique (DA1, DA2) sont reliées chacune à une source de tension bipolaire commandée (Q1, Q2), de façon que le mot numérique relatif à chaque fréquence d'oscillateur présélectionnée, converti en valeur analogique, produise la tension continue de commande pour les diodes mélangeuses (D1, D2).

3. Mélangeur à diodes selon revendication 1 ou 2, caractérisé par le fait que les dispositifs de mémoire (S1, S2) sont constitués par des PROM ou par des E-PROM.

4. Mélangeur à diodes selon revendication 1 ou 2, caractérisé par le fait que les sources de tension bipolaires commandées (Q1, Q2) sont constituées par des amplificateurs opérationnels.

FIG.1

FIG.2

# FIG. 3

# FIG. 5

FIG. 4

0 119 439